# EUROPEAN PATENT SPECIFICATION

(11) **EP 1 727 288 B1**
(45) Date of publication and mention of the grant of the patent: **10.04.2013**
(21) Application number: 06017376.2
(22) Date of filing: 24.09.2003
(51) Int. Cl.: H03M 13/41

(54) **Determination of the bit error rate in a European DAB receiver**
Bestimmung der Bitfehlerrate in einem europäischen DAB Empfänger
Determination du taux d'erreur dans un récepteur de DAB européen

(30) Priority: 24.09.2002 KR 20020057868
(43) Date of publication of application: 29.11.2006
(62) Divisional of application: 03021563.6
(73) Proprietor: Samsung Electronics Co., Ltd., Suwon-si, Gyeonggi-do, 443-742 (KR)
(72) Inventor: Lee, Jeong-taek, Seodaemoon-gu Seoul (KR)
(74) Representative: Grünecker, Kinkeldey, Stockmair & Schwanhäusser

(56) References cited:
- EP-A- 0 865 176
- EP-A- 0 945 989
- EP-A- 0 961 432
- EP-A- 1 111 867
- US-A- 6 163 571

## Description

### BACKGROUND OF THE INVENTION

### 1. Field of the invention

The present invention relates to a European digital audio broadcasting (DAB) receiver, and more particularly, to a channel decoding apparatus.

### 2. Description of the Prior Art

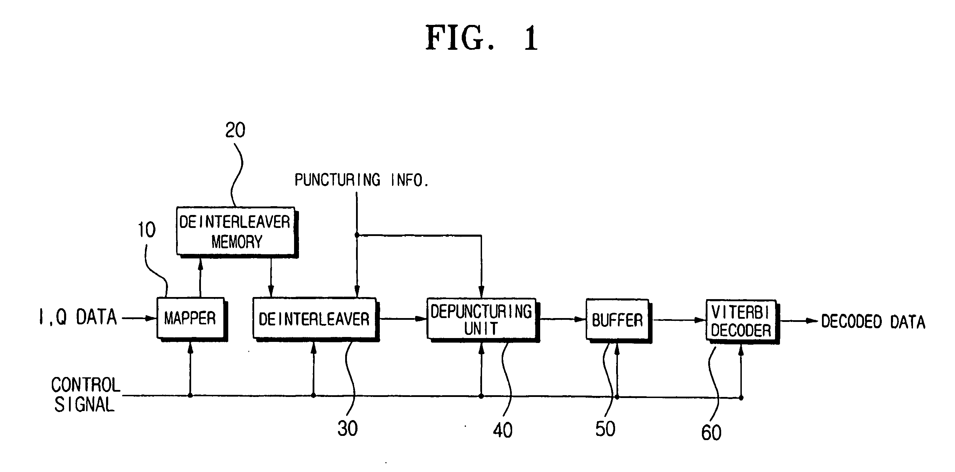

FIG. 1 is a schematic block diagram of a channel decoding apparatus for use in a general European digital audio broadcasting (DAB) receiver.

The channel decoding apparatus of the DAB receiver includes a mapper 10, a deinterleaver memory 20, a deinterleaver 30, a depuncturing unit 40, a buffer 50 and a viterbi decoder 60.

The mapper 10 stores input of I and Q data to the deinterleaver memory 20.

The deinterleaver memory 20 usually has a capacity of about 4Mbit corresponding to 16 common interleaved frames (CIF) in the viterbi decoding, and stores data inputted from the mapper 10.

The deinterleaver 30 reads data one by one in the interleaving order at transmitting ends of the 16 respective CIFs (soft-decision type) based on the puncturing information. The puncturing information usually contains 4 types of puncturing vectors such as 1111, 1110, 1100, 1000 for the European DAB transmitter/receiver.

The depuncturing unit 40 performs depuncturing based on the puncturing vectors, i.e., inserts predetermined data in the place of data which are punctured at the transmitting end. More specifically, numerous data are generated from a convolution encoding on a single data at the transmitting end, and in order to enhance transmission rate of the convolution-encoded data, some data are punctured before the transmission. Based on the puncturing vectors, the depuncturing unit 40 inserts proper data, for example 7, in the punctured data as received.

The buffer 50 stores the deinterleaved and depunctured data based on the puncturing vectors and then outputs 4-bit in soft-decision.

Table 1 below shows respective data D after convolution encoding, puncturing and depuncturing.

**[Table 1]**

| | | | | |
|---|---|---|---|---|
| Data | D | | | |
| Convolution-encoded data | 4D₀, 4D₁, 4D₂, 4D₃, | | | |
| Puncturing vector | 1 1 1 1 | 1 1 1 0 | 1 1 0 0 | 1 0 0 0 |
| Punctured data | 4D₀ 4D₁ 4D₂ 4D₃ | 40₀ 4D₁ 4D₂ | 4D₀ 4D₁ | 4D₀ |
| Depunctured data | 4D₀ 4D₁ 4D₂ 4D₃ | 4D₀ 4D₁ 4D₂ 7 | 4D₀ 4D₁ 7 7 | 4D₀ 7 7 7 |

The viterbi decoder 60 processes viterbi decoding with respect to the depunctured data of the buffer 50 in the unit of 4-bit soft-decision data, namely, 4D₀ 4D₁ 4D₂ 4D₃, 4D₀ 4D₁ 4D₂ 7, 4D₀ 4D₁ 7 7, 4D₀ 7 7 7 (4D = 4bit data).

However, the channel decoding apparatus of the conventional European DAB receiver has the following drawbacks.

The first problem is related to the address structure of the deinterleaver memory 20, the example of which is shown below.

### [Example 1]

| | |
|---|---|
| CIF address (4bit) | DATA address (15 bit) |

As shown in the Example 1, 4-bit CIF address is set as an upper address, while 15-bit data address of each CIF is set as a lower address. Accordingly, the deinterleaver memory 20 stores data in an absolute address which is the combination of the 4-bit CIF address and 15-bit data address. Since the CIF address and the data address are operated independently from each other, deinterleaving becomes easier. However, there is a drawback that the CIF always has an empty space which is not filled with the data. This means empty addresses in the respective CIFs and subsequent wastage of memory space.

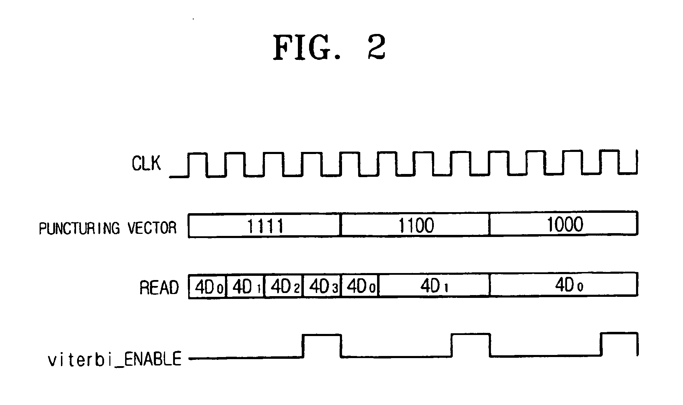

The second problem of the channel decoding apparatus of the conventional European DAB receiver is the decoding time. FIG. 2 is a timing view illustrating the operation of the channel decoding apparatus of FIG. 1.

As shown in the timing view of FIG. 2, with the 'READ' signal, data stored in the deinterleaver memory 20 are read at irregular timing based on the puncturing vectors. For example, with the punctured vector '1111', data 4D₀, 4D₁, 4D₂, 4D₃ are read one by one in correspondence with the clock signal CLK. With the puncturing vector '1000', only one data, i.e., 4D₀ is read during the 4 clock signals. Meanwhile, with the reception of signal Viterbi_ENABLE to the viterbi decoder 60, data are decoded with regular periodicity. The Viterbi_ENABLE signal is applied with 4 clock periodicity. While there is no waste of clock signals with the puncturing vector '1111', 2 clock signals are wasted with the puncturing vector '1100' and 3 clock signals are wasted with the puncturing vector '1000'. As a result, decoding time and power consumption increases with respect to the entire frames of the DAB data.

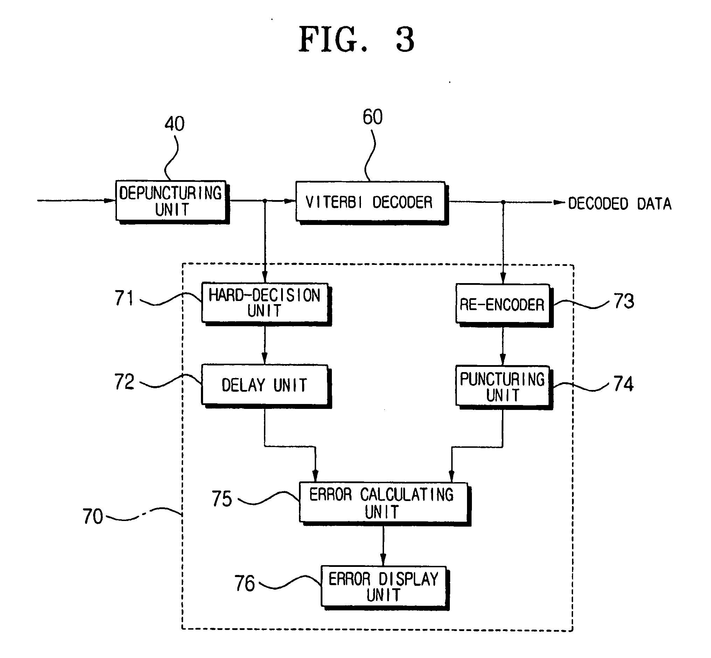

Thirdly, there is a problem in a performance measuring equipment 70 of the viterbi decoder 60 which is schematically shown in the block diagram of FIG. 3. The performance of the viterbi decoder 60 is determined by measuring error rate, i.e., by estimating the data before the viterbi decoding using output signals from the viterbi decoder 60 and then comparing the estimated data with the input data to the viterbi decoder 60.

As shown in FIG. 3, the performance measuring equipment 70 of the viterbi decoder 60 includes a hard-decision unit 71, a delay unit 72, a re-encoder 73, a puncturing unit 74, an error calculating unit 75 and an error display unit 76.

The hard decision unit 71 converts the soft-decision data input to the viterbi decoder 60 into hard-decision data. The hard-decision data are delayed at the delay unit 72 by the duration as much as the data are decoded and output from viterbi decoder 60. The data are output after the delay. When the decoded data are output from the viterbi decoder 60, output data are convolution-encoded at the re-encoder 73 and punctured at the puncturing unit 74 according to the puncturing information. The punctured data from the puncturing unit 74 and the delayed data from the delay unit 72 are input to the error calculating unit 75 to be compared with the data which are not punctured, and as a result, an error rate is calculated. The calculated error rate is displayed externally through the error display unit 75.

In the conventional performance measuring apparatus 70, the puncturing unit 74, which is the same as the depuncturing unit 40 of the channel decoding apparatus, is additionally required to generate puncturing vectors for the puncturing of the convolution-encoded data. Accordingly, the system becomes complicated and unnecessary power consumption grows.

EP-A-0 945 989 discloses depuncturing, wherein the codes output by a depuncturing unit and values output from a best path unit are compared by an error unit to generate a value for the error rate in the received signal.

EP 0 865 176 A2 discloses a puncturing vector inserting with comparing means that compare a delayed signal and a corrected convolution coding signal from a re-encoding means.

EP 0 961 432 A2 discloses a system control unit detecting a bit error of a received DAB signal.

EP 1 111 867 A2 discloses a received quality determining section and signal acquisition and frequency synchronization in multi-carrier systems.

### SUMMARY OF THE INVENTION

It is an object of the present invention to realize a performance measuring apparatus for a viterbi decoder of simple structure and to reduce power consumption and complexity of the system.

This object is solved by the features of the independent claims.

Advantageous embodiments are disclosed by the subclaims.

### BRIEF DESCRIPTION OF THE DRAWINGS

The above objects and other features of the present invention will become more apparent by describing in detail a preferred embodiment thereof with reference to the attached drawings, in which:
FIG. 1 is a schematic block diagram of a channel decoding apparatus of a conventional digital audio broadcasting (DAB) receiver;
FIG. 2 is a timing view illustrating the operation of FIG. 1;
FIG. 3 is a schematic block diagram of a performance measuring apparatus of the viterbi decoder of FIG. 1;
FIG. 4 is a schematic block diagram of a channel decoding apparatus of a European digital audio broadcasting (DAB) receiver according to one example;
FIG. 5 is a view illustrating a memory address structure ;
FIG. 6 is a flowchart illustrating a channel decoding method;
FIG. 7 is a timing view illustrating the operation according to another example of decoding;
FIG. 8 is a flowchart illustrating a channel decoding method;
FIG. 9 is a schematic block diagram of a performance measuring apparatus of a channel decoding apparatus according to an embodiment of the present invention; and
FIG. 10 is a flowchart illustrating a performance measuring method of the channel decoding apparatus according to the embodiment of the present invention.

### DETAILED DESCRIPTION OF THE PREFERRED EMBODIMENT

Hereinafter, the present invention will be described in detail with reference to the accompanying drawings.

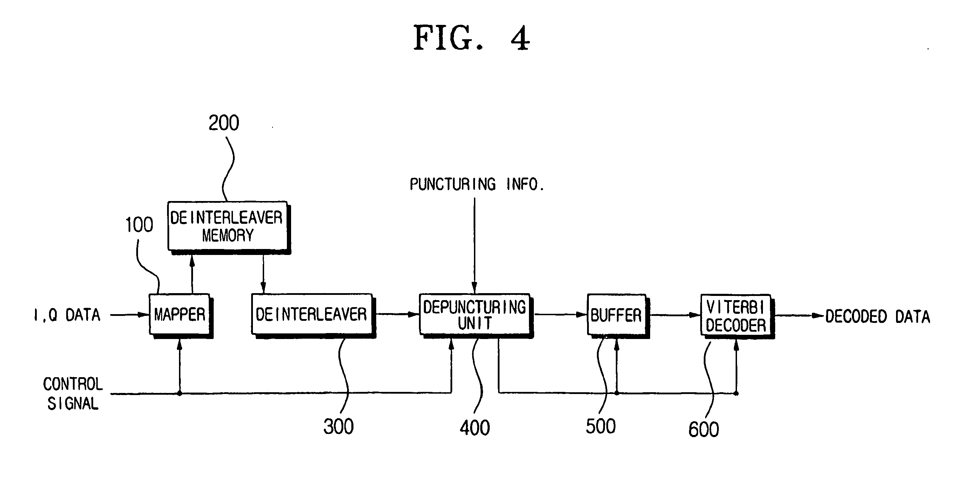

FIG. 4 is a schematic block diagram of a channel decoding apparatus for use in a digital audio broadcasting (DAB) receiver. Referring to FIG. 4, also the embodiment of the present invention will be described in greater detail.

The channel decoding apparatus includes a mapper 100, a deinterleaver memory 200, a deinterleaver 300, a depuncturing unit 400, a buffer 500 and a viterbi decoder 600.

The mapper 100 maps and stores input of I and Q data to the deinterleaver memory 200.

The deinterleaver memory 200 has a capacity about 4Mbit that corresponds to the 16 common interleaved frames (CIFs), and also has an absolute address which is the combination of 4-bit CIF address and 15-bit data address.

The deinterleaver 300 processes deinterleaving, i.e., reads the data of the 16 CIFs stored in the deinterleaver memory 200 one by one according to the interleaving order at the transmitting end. Instead of reading the data based on the puncturing information, the deinterleaver 300 reads data at a regular timing based on the puncturing information.

Based on the puncturing information, the depuncturing unit 400 inserts predetermined data in the place of the punctured data which are punctured at the transmitting end. For example, with the puncturing data of '1000', the depuncturing unit 400 inserts '7', which is a median soft-decision data, in the place of three punctured data. Then the depuncturing unit 400 outputs the depunctured data.

The buffer 500 stores 4-bit data in soft-decision i.e., stores 16-bit deinterleaved and depunctured data, and outputs the data to the soft-decision viterbi decoder 600.

The viterbi decoder 600 processes viterbi decoding with respect to the 16-bit data inputted from the buffer 500. Operation of the viterbi decoder 600 under the control of the depuncturing unit 400 will be described later with respect to the second preferred embodiment.

Hereinbelow, examples of a channel decoding apparatus and an embodiment of the present invention will be described in greater detail with reference to the accompanying drawings.

According to one example the address structure of the deinterleaver memory 200 is improved and storage efficiency of the memory is subsequently enhanced.

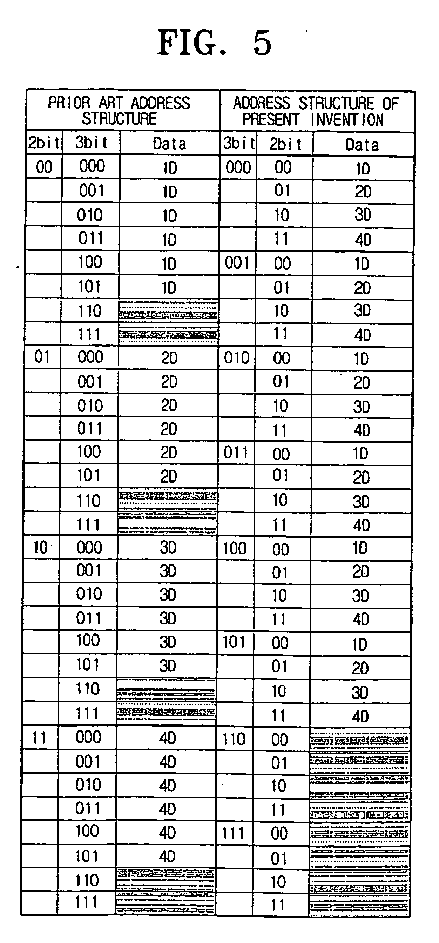

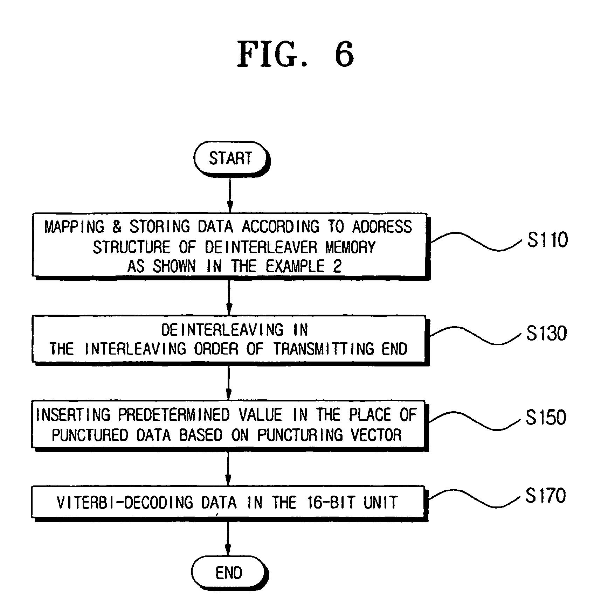

The example 2 and the table of FIG. 5 will be referred to, while describing the improved address structure according to the first preferred embodiment. FIG. 6 is for explaining a channel decoding method according to the improved address structure.

The address structure of the deinterleaver memory 20 is as follows:

### [Example 2]

| | |
|---|---|
| DATA address (15 bit) | CIF address (4 bit) |

The deinterleaver memory 200 has the 15-bit address data of the CIF as an upper address, and 4-bit address for the CIF as a lower address.

Described below with reference to the table of FIG. 5 is the mapping of the data stored according to the above memory address structure as compared to that of the data stored according to the conventional memory address structure.

For the sake of convenience in describing the embodiment, the 4-bit CIF address is assumed to be 2-bit CIF address, and 15-bit data address is assumed to be 3-bit data address. Also, the description with reference to FIG. 5 will be made mainly in terms of the empty address spaces of the conventional address structure and the address structure of the first preferred embodiment.

As shown in FIG. 5, in the conventional memory which has an address structure having CIF address as upper address and data address as lower address (Example 1), data 1D to 4D are sequentially stored in the respective CIFs, leaving empty addresses 110 and 111 (indicated as dark cells) in the respective CIFs according to size of the data being stored.

Compared to the conventional memory, in this memory of the example of an address structure that has data address as upper address and CIF address as lower address (Example 2), data are mapped with respect to the address structure in a linear manner, thus leaving empty address spaces collectively at the lower portion of the entire memory address structure. The empty address spaces can be additionally used for storing other data, and as a result, storage efficiency of the memory improves.

The mapper 100 stores the input data according to the address structure of the deinterleaver memory 200 as shown in the example 2 (step S110). Next, the deinterleaver 300 processes deinterleaving, i.e., reads the stored data in the address structure of the deinterleaver memory 200 as shown in the example 2 one by one (step S130). Based on the puncturing information, i.e., based on the puncturing vectors, the depuncturing unit 400 inserts predetermined data in the place of data that are punctured at the transmitting end (step S150). The soft-decision viterbi decoder 600 processes viterbi decoding with respect to the data in the 16-bit data unit (step S170).

The deinterleaver memory 200, which has the address structure such as the one shown in the example 2 , can additionally store up to 12288-bit CIF data in the empty memory spaces, if considering the general 4Mbit memory capacity and OFDM symbol data. As a result, memory capacity is fully utilized.

Next, according to another example, the decoding operation of the viterbi decoder 600 is appropriately controlled so that overall decoding time can be shortened.

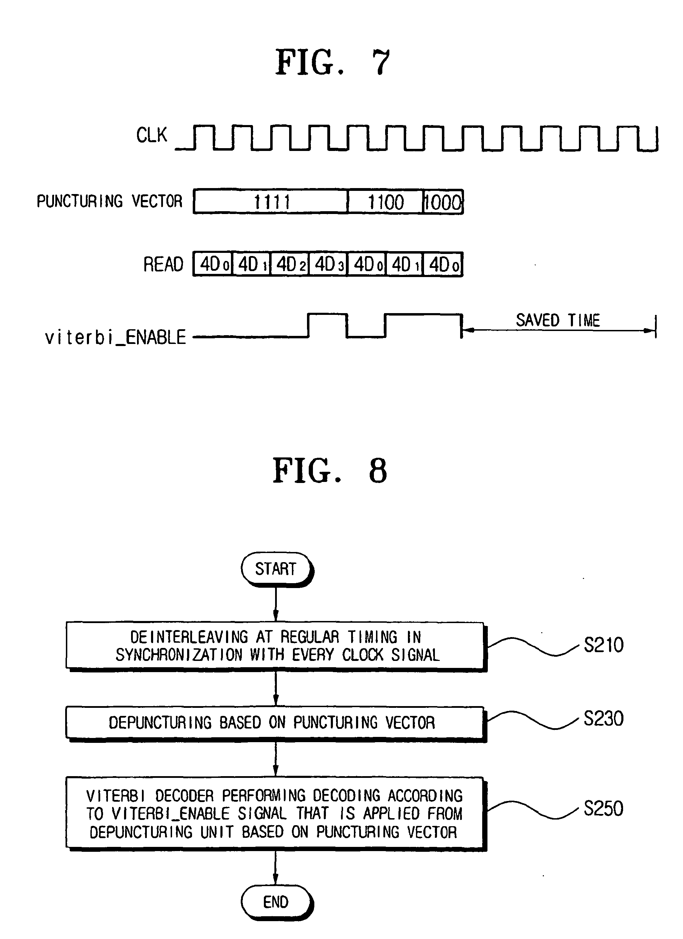

FIG. 7 is a timing view, and FIG. 8 is a flowchart for illustrating the channel decoding method according to the another example, which will be described in greater detail below with reference to FIGS. 7 and 8.

The deinterleaver 300, with the reception of READ signal in synchronization with every clock signal CLK, processes deinterleaving, i.e., reads the stored data (4D₀ 4D₁ 4D₂ 4D₃, 4D₀ 4D₁ 4D₀...) from the deinterleaver memory 200 at a regular timing (step S210).

Next, based on the puncturing information inputted from the depuncturing unit 400, predetermined data are inserted in the deinterleaved data which are inputted at regular timing, i.e., the predetermined data are inserted in the place of the punctured data of the incoming deinterleaved data (step S230).

The data after the deinterleaving and depuncturing are inputted to the soft-decision viterbi decoder 600 in the 16-bit data unit.

The viterbi decoder 600 receives Viterbi_ENABLE signal from the depuncturing unit 400 based on the puncturing vectors, and processes decoding accordingly (step S250).

For example, with the puncturing vector '1111', the depuncturing unit 400 applies Viterbi_ENABLE to the viterbi decoder 600 when the last data i.e., 4D₃ among deinterleaved data 4D₀ 4D₁ 4D₂ 4D₃ is inputted to the viterbi decoder 600. With the puncturing vector '1100', the depuncturing unit 400 applies Viterbi_ENABLE to the viterbi decoder 600 when the last data i.e., 4D₁ among deinterleaved data 4D₀ 4D₁ is inputted to the viterbi decoder 600. The depunctured data are concurrently inputted as the Viterbi_ENABLE is applied to the viterbi decoder 600.

Because the Viterbi_ENABLE is applied from the depuncturing unit 400 to the viterbi decoder 600 based on the puncturing vector, decoding time can be shortened. For example, in the case where there are much of the punctured data such as in the case with the puncturing vector '1000', decoding time becomes shorter as much as 3 clock CLK signals as compared to the conventional cases.

Considering the entire DAB frames into account, decoding time of the channel decoding apparatus is reduced substantially and power consumption is subsequently reduced.

Next, according to an embodiment of the present invention the performance measuring apparatus 700 for determining performance of the viterbi decoder 600 is designed with simple circuit construction and thus consumes less power.

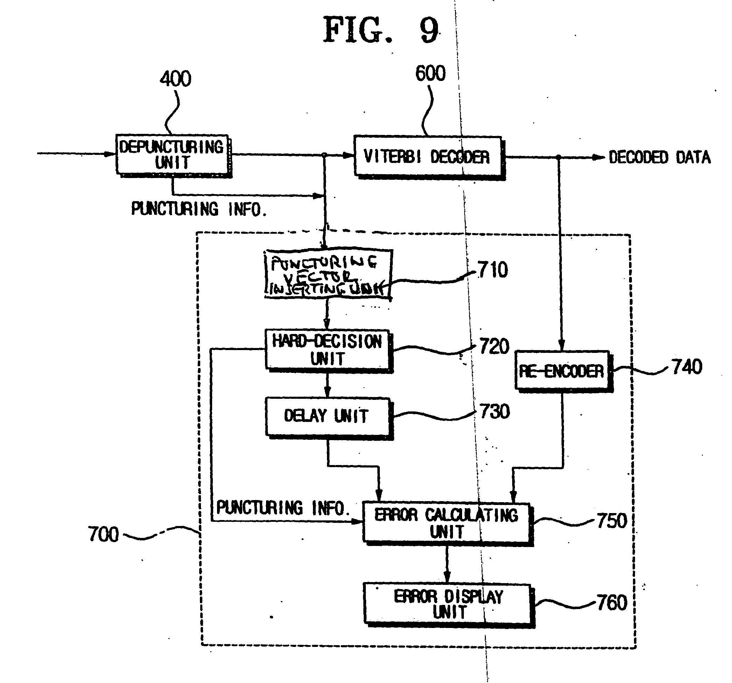

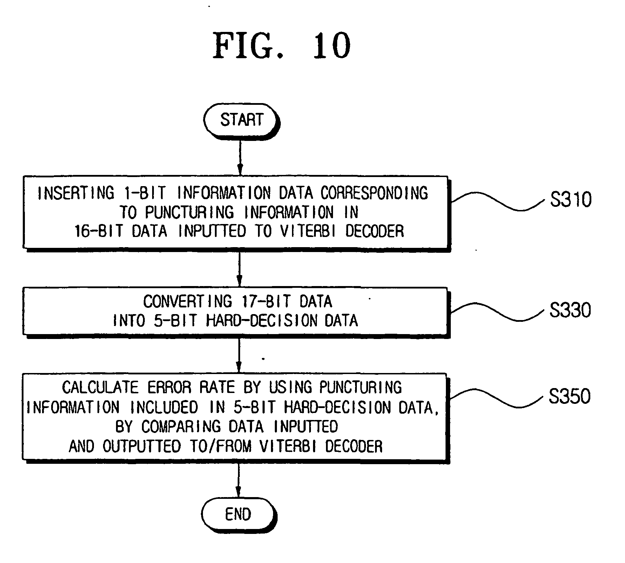

FIG. 9 is a schematic block diagram of the performance measuring apparatus 700 of the channel decoding apparatus according to the embodiment of the present invention, and FIG. 10 is a flowchart illustrating a performance measuring method of the performance measuring apparatus 700 of FIG. 9.

The embodiment of the present invention will be described in greater detail below with reference to FIGS. 9 and 10.

The performance measuring apparatus 700 includes a puncturing vector inserting unit 710, a hard-decision unit 720, a delay unit 730, a re-encoder 740, an error calculating unit 750 and an error display unit 760.

The puncturing vector inserting unit 710 inserts puncturing vector information in the depunctured data.

As described earlier, in the general European DAB system, the puncturing vectors usually fall into four types, i.e., 1111, 1110, 1100, 1000 with respect to the hard-decision, with each bits being 4-bit soft-decision data. '1' denotes no-puncturing, and '0' denotes puncturing. Left end is the most significant bit (MSB) and thus input starts from the left end. As shown in the puncturing vectors, MSB is always set to '1' and all the bits after 0bit are always set to '0'. The puncturing vector information can be estimated by using 2-bit data which corresponds to the number of zeros "0" of the puncturing vector. Estimating of the puncturing vector will be described in greater detail below. The puncturing vector inserting unit 710 adds 1 bit to the depunctured data, thereby outputting the data in which 17bit puncturing vector information is inserted. 17-bit data output from the puncturing vector inserting unit 710 is as follows:
1. With the puncturing vector '1111', output data consist '0, 4D, 4D, 4D, 4D'
2. With the puncturing vector '1110', output data consist '1, 0, 4D, 4D, 4D'
3. With the puncturing vector '1100', output data consist '1, 8, 7, 4D, 4D'
4. With the puncturing vector '1000', output data consist '1, 8, 8, 7, 4D'.
(where, '4D' denotes 4-bit data, '7' denotes a predetermined depunctured data, and '8' denotes a predetermined data for making 2-bit information about number of '1' bits of the puncturing vectors).

The hard-decision unit 720 converts the 17-bit data from the puncturing vector inserting unit 710 into hard-decision data (step S330). Conversion of soft-decision data into hard-decision data involves the process in which the data represented by '0' to '15' are converted to be represented by '0' or '1'. For example, 14 soft-decision data is converted into '1' hard-decision data, and 2 soft-decision data is converted into '0' hard-decision data.

After the conversion, 5-bit data are outputted from the hard-decision unit 720 in the respective data structure as follows.
1. 5-bit data of '0, D, D, D, D' are outputted from the 17-bit data of '0, 4D, 4D, 4D, 4D'
2. 5-bit data of '1, 0, D, D, D' are outputted from the 17-bit data of '1, 0, 4D, 4D, 4D'
3. 5-bit data of '1, 1, 0, D, D' are outputted from the 17-bit data of '1, 8, 7, 4D, 4D'
4. 5-bit data of '1, 1, 1, 0, D' are outputted from the 17-bit data of '1, 8, 8, 7, 4D'.

The delay unit 730 delays the 5-bit hard-decision data for the duration as much as the process time of the viterbi decoder 600, and then outputs the delayed data.

The re-encoder 740, being constructed with the same circuit as the convolution encoder of the transmitting end, performs convolution encoding with respect to the data which were decoded at the viterbi decoder 600. Accordingly, the re-encoder 740 encodes a single data into plural data.

Using the puncturing information included in the hard-decision data that are delayed for the duration as much as the processing time of the viterbi decoder 600 and then outputted from the delay unit 730, the error calculating unit 750 compares the data from the re-encoder 740 with only the non-punctured bits of the hard-decision data (step S350). Puncturing vectors are extracted from the 5-bit hard-decision data respectively as follows:
1. In the case of 5-bit hard-decision data with a '0' MSB, the puncturing vector is '1111'
2. In the case of 5-bit hard-decision data with a '1' MSB and '0' bit next to the MSB, the puncturing vector is '1110'
3. In the case of 5-bit hard-decision data with a '1' MSB and '10' 2-bits next to the MSB, the puncturing vector is '1100'
4. In the case of 5-bit hard-decision data with a '1' MSB and '11' 2-bits next to the MSB, the puncturing vector is '1000'.

In other words, the error calculating unit 750 calculates an error rate of the viterbi decoder 600 based on the puncturing vectors that are estimated from the data from the delay unit 730 and from the re-encoder 740.

The error display unit 760 externally displays the error rate calculated by the error calculating unit 750.

Because the puncturing information is inserted in the depunctured data, the performance measuring apparatus 700 of the viterbi decoder 600 requires no puncturing unit (74; FIG. 4) and thus, it can be constructed in a simple design.

According to the aspect of the present invention, 1-bit puncturing information is inserted in the depunctured data by the performance measuring apparatus of the viterbi decoder. As a result, transmission signal size is reduced, and circuit design is simplified. In other words, simple circuit and less power consumption can be obtained.

The features of the present invention as described above, especially the reduced power consumption can be quite effective, considering the fact that the European digital audio broadcasting (DAB) system is used in the mobile communication applications.

Although a few preferred embodiments of the present invention have been described, it will be understood by those skilled in the art that the present invention should not be limited to the described preferred embodiments, but various changes and modifications can be made within the scope of the present invention as defined by the appended claims.

## Claims

1. A performance measuring apparatus (700) provided to a channel decoding apparatus of a European digital audio broadcasting, DAB, receiver, **characterised by** comprising:
a puncturing vector inserting unit (710) for inserting puncturing vector information according to corresponding pucturing vectors in a depunctured signal also input in a Viterbi decoder (600), wherein one bit is added to the depunctured signal and 17-bit data is output as follows:
i) 0, 4D, 4D, 4D for a puncturing vector 1 1 1 1;
ii) 1, 0, 4D, 4D, 4D for a puncturing vector 1 1 1 0;
iii) 1, 8, 7, 4D, 4D for a puncturing vector 1 1 0 0, and
iv) 1, 8, 8, 7, 4D for a puncturing vector 1 0 0 0,
wherein '4D' denotes 4-bot data of the depunctured signal, '7' denotes a predetermined depunctured data, and '8' denotes a predetermined data for making 2-bit information about the number of '1' bits of the puncturing vectors
a hard-decision unit (720) for converting the 17-bit data output from the puncturing vector inserting unit into 5-bit hard decision data used for extracting puncturing vectors;
a re-encoder (740) for convolution-encoding the signal output from the viterbi decoder (600), and
an error calculating unit (750) for calculating an error rate by comparing the data from the re-encoder with only the non-punctured bits of the hard-decision data based on the puncturing vectors extracted from the 5-bit hard-decsion data.

2. The performance measuring apparatus of claim 1, **characterised by** a delay unit (730) delaying the hard-decision data received from the hard-decision unit (720) as much as the process time of the viterbi decoder (600) and to output the delayed data to the error calculating unit (750).

3. A performance measuring method of the performance method measuring apparatus (700) provided to a channel decoding apparatus of a European digital audio broadcasting, DAB, receiver, **characterised by** the steps of:
inserting (S 310) puncturing vector information according to corresponding puncturing vectors in a depunctured signal also input in a Viterbi decoder (600), wherein one bit is added to the depunctured signal and 17-bit data is output as follows:
a) 0, 4D, 4D, 4D, 4D for a puncturing vector R 1 1 1 1;
b) 1, 0, 4D, 4D, 4D for a puncturing vector 1 1 1 0;
c) 1, 8, 7, 4D, 4D for a puncturing vector 1 1 0 0, and
d) 1, 8, 8, 7, 4D for a puncturing vector 1 0 0 0,
wherein ' 4 D ' denotes 4-bit data of the depunctured signal, ' 7 ' denotes a predetermined depunctured data, and ' 8 ' denotes a predetermined data for making 2-bit information about the number of ' 1 ' bits of the puncturing vectors;
converting (S330) the 17-bit data into 5-bit hard decision data used for extracting puncturing vectors;
re-encoding in a re-encoder the signal output from the viterbi decoder by convolution encoding, and
calculating (S350) an error rate by comparing the data from the re-encoder with only the non-punctured bits of the hard-decision data based on the puncturing vectors extracted from the 5-bit hard-decision data.

4. The performance measuring method of claim 3, **characterised by** the further step of delaying the hard-decision data for a duration as much as the process time of the viterbi decoder, and outputting the delayed data for the calculating of said error rate.

## Patentansprüche

1. Leistungsmessvorrichtung (700), die an einer Kanaldecodiervorrichtung eines europäischen DAB-Empfängers (Digital Audio Broadcasting DAB, digitaler Audiorundfunk) vorgesehen ist, **dadurch gekennzeichnet, dass** die Leistungsmessvorrichtung (700) umfasst:
eine Punktiervektor-Einfügeeinheit (710) zum Einfügen von Punktiervektorinformationen in Übereinstimmung mit entsprechenden Punktiervektoren in ein depunktiertes Signal, das auch in einen Viterbi-Decodierer (600) eingegeben wird, wobei ein Bit zu dem depunktierten Signal hinzugefügt wird und 17-Bit-Daten wie folgt ausgegeben werden:
i) 0, 4D, 4D, 4D, 4D für einen Punktiervektor 1 1 1 1,
ii) 1, 0, 4D, 4D, 4D für einen Punktiervektor 1 1 1 0,
iii) 1, 8, 7, 4D, 4D für einen Punktiervektor 1 1 0 0, und
iv) 1, 8, 8, 7, 4D für einen Punktiervektor 1 0 0 0,
wobei '4D' 4-Bit-Daten des depunktierten Signals wiedergibt, ,7' vorbestimmte depunktierte Daten wiedergibt und ,8' vorbestimmte Daten zum Erzeugen von 2-Bit-Informationen zu der Anzahl von '1'-Bits der punktierten Vektoren wiedergibt,
eine Hartentscheidungseinheit (720) zur Umwandlung der von der Punktiervektor-Einfügeeinheit ausgegebenen 17-Bit-Daten in 5-Bit-Entscheidungsdaten zur Extraktion von Punktiervektoren;
einen Neucodierer (740) zum Faltungscodieren des aus dem Viterbi-Decodierer (600) ausgegebenen Signals, und
eine Fehlerberechnungseinheit (750) zum Berechnen einer Fehlerrate durch das Vergleichen der Daten aus dem Neucodierer mit nur den nicht-punktierten Bits der Hartentscheidungsdaten auf der Basis der aus den 5-Bit-Hartentscheidungsdaten extrahierten Punktiervektoren.

2. Leistungsmessvorrichtung nach Anspruch 1, **gekennzeichnet durch** eine Verzögerungseinheit (730), die die von der Hartentscheidungseinheit (720) empfangenen Hartentscheidungsdaten um eine der Verarbeitungszeit des Viterbi-Decodierers (600) entsprechende Zeitdauer verzögert und die verzögerten Daten zu der Fehlerberechnungseinheit (750) ausgibt.

3. Leistungsmessverfahren der Leistungsmessvorrichtung (700), die an einer Kanaldecodiervorrichtung eines europäischen DAB-Empfängers (Digital Audio Broadcasting DAB, digitaler Audiorundfunk) vorgesehen ist, **gekennzeichnet durch** die folgenden Schritte:
Einfügen (S310) von Punktiervektorinformationen in Übereinstimmung mit entsprechenden Punktiervektoren in ein depunktiertes Signal, das auch in einen Viterbi-Decodierer (600) eingegeben wird, wobei ein Bit zu dem depunktierten Signal hinzugefügt wird und 17-Bit-Daten wie folgt ausgegeben werden:
a) 0, 4D, 4D, 4D, 4D für einen Punktiervektor 1 1 1 1,
b) 1, 0, 4D, 4D, 4D für einen Punktiervektor 1 1 1 0,
c) 1, 8, 7, 4D, 4D für einen Punktiervektor 1 1 0 0, und
d) 1, 8, 8, 7, 4D für einen Punktiervektor 1 0 0 0,
wobei '4D' 4-Bit-Daten des depunktierten Signals wiedergibt, '7' vorbestimmte depunktierte Daten wiedergibt und ,8' vorbestimmte Daten zum Erzeugen von 2-Bit-Informationen zu der Anzahl von '1'-Bits der punktierten Vektoren wiedergibt,
Wandeln (S330) der 17-Bit-Daten zu 5-Bit-Hartentscheidungsdaten, die für das Extrahieren von Punktiervektoren verwendet werden,
Neucodieren in einem Neucodierer des aus dem Viterbi-Decodierer ausgegebenen Signals durch eine Faltungscodierung, und
Berechnen (S350) einer Fehlerrate **durch** das Vergleichen der Daten aus dem Neucodierer mit nur den nicht-punktierten Bits der Hartentscheidungsdaten auf der Basis der aus den 5-Bit-Hartentscheidungsdaten extrahierten Punktiervektoren.

4. Leistungsmessverfahren nach Anspruch 3, **gekennzeichnet durch** einen weiteren Schritt zum Verzögern der Hartentscheidungsdaten für eine der Verarbeitungszeit des Viterbi-Decodierers entsprechende Zeitdauer und zum Ausgeben der verzögerten Daten für das Berechnen der Fehlerrate.

## Revendications

1. Dispositif de mesure de performances (700) prévu dans un appareil de décodage de voie d'un récepteur européen de diffusion audio numérique, DAB, **caractérisé en ce qu'**il comprend :
une unité d'insertion de vecteur de poinçonnage (710) pour insérer des informations de vecteur de poinçonnage en fonction de vecteurs de poinçonnage correspondants dans un signal dépoinçonné également appliqué à l'entrée d'un décodeur de Viterbi (600), dans lequel un bit est ajouté au signal dépoinçonné et des données sur 17 bits sont fournies en sortie comme suit :
i) 0, 4D, 4D, 4D pour un vecteur de poinçonnage 1111 ;
ii) 1, 0, 4D, 4D, 4D pour un vecteur de poinçonnage 1110 ;
iii) 1, 8, 7, 4D, 4D pour un vecteur de poinçonnage 1100 ;
iv) 1, 8, 8, 7, 4D pour un vecteur de poinçonnage 1000 ;
dans lequel « 4D » représente des données sur 4 bits du signal dépoinçonné, « 7 » représente des données dépoinçonnées prédéterminées et « 8 » représente des données prédéterminées pour constituer des informations de 2 bits concernant le nombre de bits à « 1 » des vecteurs de poinçonnage ;
une unité de décision ferme (720) pour convertir les données sur 17 bits fournies en sortie par l'unité d'insertion de vecteur de poinçonnage en données de décision ferme sur 5 bits utilisées pour extraire les vecteurs de poinçonnage ;
un recodeur (740) pour effectuer un codage convolutionnel du signal fourni en sortie par le décodeur de Viterbi (600), et
une unité de calcul d'erreur (750) pour calculer un taux d'erreur en comparant les données provenant du recodeur uniquement avec les bits non poinçonnés des données de décision ferme en se basant sur les vecteurs de poinçonnage extraits des données de décision ferme sur 5 bits.

2. Dispositif de mesure de performances selon la revendication 1, **caractérisé par** une unité de retard (730) retardant les données de décision ferme reçues depuis l'unité de décision ferme (720) d'un temps égal au temps de traitement du décodeur de Viterbi (600) et pour fournir en sortie les données retardées à l'unité de calcul d'erreur (750).

3. Procédé de mesure de performances du dispositif de mesure de performance (700) prévu dans un appareil de décodage de voie d'un récepteur européen de diffusion audio numérique, DAB, **caractérisé par** les étapes consistant à :
insérer (S310) des informations de vecteur de poinçonnage en fonction de vecteurs de poinçonnage correspondants dans un signal dépoinçonné également appliqué à l'entrée d'un décodeur de Viterbi (600), dans lequel un bit est ajouté au signal dépoinçonné et des données sur 17 bits sont fournies en sortie comme suit :
a) 0, 4D, 4D, 4D pour un vecteur de poinçonnage 1111 ;
b) 1, 0, 4D, 4D, 4D pour un vecteur de poinçonnage 1110 ;
c) 1, 8, 7, 4D, 4D pour un vecteur de poinçonnage 1100 ;
d) 1, 8, 8, 7, 4D pour un vecteur de poinçonnage 1000 ;
dans lequel « 4D » représente des données sur 4 bits du signal dépoinçonné, « 7 » représente des données dépoinçonnées prédéterminées et « 8 » représente des données prédéterminées pour constituer des informations de 2 bits concernant le nombre de bits à « 1 » des vecteurs de poinçonnage ;
convertir (S330) les données sur 17 bits en données de décision ferme sur 5 bits utilisées pour extraire les vecteurs de poinçonnage ;
recoder dans un recodeur le signal fourni en sortie par le décodeur de Viterbi (600), par codage convolutionnel, et
calculer (S350) un taux d'erreur en comparant les données provenant du recodeur uniquement avec les bits non poinçonnés des données de décision ferme en se basant sur les vecteurs de poinçonnage extraits des données de décision ferme sur 5 bits.

4. Procédé de mesure de performances selon la revendication 3, **caractérisé par** l'étape supplémentaire de retard des données de décision ferme d'un temps égal au temps de traitement du décodeur de Viterbi et de fourniture en sortie des données retardées pour le calcul dudit taux d'erreur.
